(19) **Europäisches Patentamt / European Patent Office / Office européen des brevets**

(11) **EP 3 517 836 A1**

(12) **EUROPEAN PATENT APPLICATION**
published in accordance with Art. 153(4) EPC

(43) Date of publication:
**31.07.2019 Bulletin 2019/31**

(21) Application number: **17852572.1**

(22) Date of filing: **28.02.2017**

(51) Int Cl.:
*F21V 3/04* (2018.01)          *F21S 2/00* (2016.01)
*G02B 5/02* (2006.01)          *G02B 5/22* (2006.01)
*H01L 33/00* (2010.01)        *H01L 33/58* (2010.01)
*F21W 131/10* (2006.01)      *F21W 131/402* (2006.01)
*F21W 131/405* (2006.01)    *F21Y 103/10* (2016.01)
*F21Y 113/17* (2016.01)       *F21Y 115/10* (2016.01)

(86) International application number:
**PCT/JP2017/007911**

(87) International publication number:
**WO 2018/055791 (29.03.2018 Gazette 2018/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **21.09.2016   JP 2016183858**

(71) Applicant: **Sekisui Plastics Co., Ltd.
Osaka-shi
Osaka 530-8565 (JP)**

(72) Inventors:
• **KIMURA, Kazuma
Koka-shi
Shiga 528-0056 (JP)**
• **ISHIMORI, Fumitaka
Koka-shi
Shiga 528-0056 (JP)**

(74) Representative: **Müller-Boré & Partner
Patentanwälte PartG mbB
Friedenheimer Brücke 21
80639 München (DE)**

(54) **LED LIGHTING COVER LIGHT-DIFFUSER AND APPLICATION THEREFOR**

(57)     An LED luminaire cover light diffuser that can achieve a clear contrast of a target object to enhance colors of the target object, by reducing yellow light around 550 nm that is a component that leads to a somber visual appearance of the target object when illuminated, and a use thereof are provided. The LED luminaire cover light diffuser is used for an illumination cover of an LED luminaire that illuminates a target object to enable the target object to be seen. The LED luminaire cover light diffuser includes base resin; light diffusing agent; and a coloring matter that at least partially absorbs light in a wavelength range from 500 to 600 nm. The LED luminaire cover light diffuser achieves a relative value of spectral radiance at a wavelength of 450 nm within a range from 1.60 to 15 with the spectral radiance at the wavelength of 550 nm defined as 1, when the spectral radiance is measured with a specific white LED used as a measurement light source and with the LED luminaire cover light diffuser provided to cover the white LED.

Fig.5

EP 3 517 836 A1

**Description**

Technical Field

The present invention relates to a light emitting diode (LED) luminaire cover light diffuser, diffusing light from an LED light source, used for an LED luminaire cover of an LED luminaire (for example, for an LED light bulb or a light bulb-type LED luminaire, a straight-tube LED luminaire, an LED desk stand or an LED desk stand light, an LED ceiling light, etc.) including the LED light source that illuminates a target object so that the target object can be seen, and to its use (LED luminaire).

Background Art

Recently, in the field of illumination, power saving and other schemes for higher efficiency have been required as the electric power charge increases, and use of luminaires that include LED light sources (LED luminaire) is widespread.

An LED light source is highly directional. In order to alleviate glare, an LED luminaire having an LED light source is provided with a semi-transparent light diffusion cover for an LED luminaire which surrounds the LED light source and has a light diffusion function for diffusing light from the LED light source.

Conventionally known light diffusers for LED luminaire covers include a light diffuser for an LED luminaire cover in which transparent inorganic particles (such as calcium carbonate particles and barium sulfate particles) or transparent resin particles (such as crosslinked acrylic-based resin particles, crosslinked acrylic-styrene copolymer particles, and polystyrene-based particles) are blended in a transparent thermoplastic resin (such as an acrylic-based resin or a polycarbonate-based resin).

A known LED luminaire cover has its wavelength properties adjusted by addition of dyes. For example, PTL1 describes an LED illumination light filter that includes translucent resin containing a red dye and a yellow dye. The filter passes 90% of the light with a wavelength of 600 nm and more and reduces light with a wavelength of 450 nm to 485 nm. This LED illumination light filter can weaken blue light (B light) out of R (red) light, G (green) light, and B (blue) light included in the LED illumination light, while maintaining white LED illumination light.

PTL2 describes an LED luminaire cover in which 0.01 to 1 part by weight of orange dye and /or yellow dye with a maximum absorption wavelength of 500 nm or less is added to 98 to 99.989 parts by weight of resin, whereby the LED luminaire cover has an absorption limit wavelength of 470 to 530 nm, while maintaining 80% or higher transmittance of light with a wavelength of 555 to 800 nm.

Citation List

Patent Literature

PTL1: Japanese Patent Application Publication No. 2014-170082
PTL2: Japanese Patent Application Publication No. 2010-170866

Summary of Invention

Technical Problem

Light from white LED light sources, which are general-use LED chips used in offices and houses, include much yellow light with a wavelength around 550 nm. When a luminaire is used to illuminate a target object, yellow light with a wavelength around 550 nm included in the light from the luminaire dulls the color tones (red, green, and the like) of the target object. Therefore, when the target object is a food product (in particular, fresh food) or a display item (for example, a work of art), there is demand for showing the target object more vividly and enhancing the colors of the target object.

A known high-color LED light source shows the target object vividly by enhancing the color tones of the target object when illuminated, but such an LED light source is expensive. In addition, enhancement of the color tones of the target object depends on the structure of the LED chip. Thus, enhancement of the color tones of the target object remains at a limited degree, and it is difficult to provide further enhancement of the color tones.

The LED luminaire covers described in PTL1 and PTL2 selectively reduce blue light with a wavelength of 450 nm to 485 nm or light with a wavelength of 530 nm or less (blue light and green light), but do not reduce yellow light with a wavelength around 550 nm relative to light of other colors. The LED luminaire covers described in PTL1 and PTL2 cannot enhance the color tones of the target object by reducing yellow light around 550 nm.

The present invention is made in view of the above-described problem, and an object of the present invention is to provide an LED luminaire cover light diffuser that can achieve a clear contrast of a target object to enhance colors of the target object, by reducing yellow light around 550 nm that is a component that leads to a somber visual appearance of the target object when illuminated, and an LED luminaire using the LED luminaire cover light diffuser. Solution to Problem

To solve the above-described problems, an LED luminaire cover light diffuser according to a first aspect of the present invention is used for an illumination cover of an LED luminaire that illuminates a target object to enable the target object to be seen. The LED luminaire cover light diffuser includes base resin; light diffusing agent; and a coloring matter that at least partially absorbs light in a wavelength range from 500 to 600 nm. The LED luminaire cover light diffuser achieves a relative value of spectral radiance at a wavelength of 450 nm within a range from 1.60 to 15 with the spectral radiance at the wavelength of 550 nm defined as 1, when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

To solve the above-described problems, an LED luminaire cover light diffuser according to a second aspect of the present invention is used for an illumination cover of an LED luminaire that illuminates a target object to enable the target object to be seen. The LED luminaire cover light diffuser includes 100 parts by weight of base resin; 0.1 to 5 parts by weight of light diffusing agent; and 0.1 to 10 ppm per weight of a coloring matter having a maximum absorption peak in a wavelength range from 550 to 600 nm.

An LED luminaire according to the first aspect of the present invention includes the LED luminaire cover light diffuser according to the first or second aspect of the present invention.

An LED luminaire according to the second aspect of the present invention illuminates a target object to enable the target object to be seen, and the LED luminaire includes an LED; and an LED luminaire cover including base resin, light diffusing agent, and a coloring matter that at least partially absorbs light in a wavelength range from 500 to 600 nm. With the LED luminaire, the spectral radiance at the wavelength of 450 nm is higher than the spectral radiance at the wavelength of 550 nm, with the difference between the spectral radiance at the wavelength of 450 nm and the spectral radiance at the wavelength of 550 nm being within a range from 0.05 to 0.3 $W \cdot sr^{-1}m^{-2}nm^{-1}$.

With these configurations, the LED luminaire can have smaller spectral radiance at the wavelength of 550 nm relative to the spectral radiance at the wavelength of 450 nm. Thus, the yellow light around 550 nm that is a component that leads to a somber visual appearance of a target object when illuminated, can be reduced relative to the blue light with the wavelength around 450 nm which is one of the three primary colors. Thus, a clear contrast of the target object can be achieved to enhance the color of the target object. For example, for a target object with many red portions such as meat, the red can be enhanced to give a fresh impression. For a target object with many green and red portions such as vegetable, green and red can be enhanced to give a fresh impression.

The LED luminaire cover light diffusers according to the first and the second aspects of the present invention include the light diffusing agent, so that the light from the LED light source can be diffused. As a result, when used together with an LED luminaire, the LED luminaire cover light diffusers can achieve an LED luminaire so that dot-like appearance of the LED light source (LED chip for example) can be reduced or eliminated, and glare can be alleviated.

The LED luminaires according to the first and the second aspects of the present invention include the LED luminaire cover light diffuser including the light diffusing agent so that the dot-like appearance of the LED light source (LED chip for example) can be reduced or eliminated, and glare can be alleviated.

Advantageous Effects of Invention

The present invention can provide an LED luminaire cover light diffuser that can achieve a clear contrast of a target object to enhance colors of the target object, by reducing yellow light around 550 nm that is a component that leads to a somber visual appearance of the target object when illuminated, and an LED luminaire using the LED luminaire cover light diffuser.

Brief Description of Drawings

Fig. 1 is a perspective view of an LED luminaire cover light diffuser having a single-layer structure according to one embodiment of the present invention.
Fig. 2 is a perspective view of an LED luminaire cover light diffuser having a three-layer structure according to another embodiment of the present invention.

Fig. 3 is a perspective view of an LED luminaire cover light diffuser having a three-layer structure according to still another embodiment of the present invention.

Fig. 4 is a perspective view of an LED luminaire cover light diffuser having a three-layer structure according to yet still another embodiment of the present invention.

Fig. 5 is a graph illustrating spectral radiance measured for an LED luminaire of Example 1 together with spectral radiance measured for each of LED luminaires with a white LED and a high-color LED covered by an LED luminaire cover light diffuser including no coloring matter.

Fig. 6 is a graph illustrating spectral radiance measured for an LED luminaire of Example 2 together with spectral radiance measured for each of LED luminaires with a white LED and a high-color LED covered by an LED luminaire cover light diffuser including no coloring matter.

Fig. 7 is a graph illustrating spectral radiance measured for an LED luminaire of Example 3 together with spectral radiance measured for each of LED luminaires with a white LED and a high-color LED covered by an LED luminaire cover light diffuser including no coloring matter.

Fig. 8 is a graph illustrating spectral radiance measured for a white LED together with spectral radiance measured for an LED luminaire with a white LED covered by an LED luminaire cover light diffuser including no coloring matter.

Description of Embodiments

The present invention is described in detail below.

[LED luminaire cover light diffuser]

An LED luminaire cover light diffuser according to a first aspect of the present invention is used for an illumination cover of an LED luminaire that illuminates a target object to enable the target object to be seen. The LED luminaire cover light diffuser includes base resin, light diffusing agent, and a coloring matter that at least partially absorbs light in a wavelength range from 500 to 600 nm. The LED luminaire cover light diffuser achieves a relative value of spectral radiance at a wavelength of 450 nm within a range from 1.60 to 15 with the spectral radiance at the wavelength of 550 nm defined as 1, when the spectral radiance (spectral radiance of an LED luminaire manufactured by using the LED luminaire cover light diffuser as an LED luminaire cover covering a white LED) is measured with the white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

An LED luminaire cover light diffuser according to a second aspect of the present invention is used for an illumination cover of an LED luminaire that illuminates a target object to enable the target object to be seen. The LED luminaire cover light diffuser includes 100 parts by weight of base resin; 0.1 to 5 parts by weight of light diffusing agent; and 0.1 to 10 ppm per weight of a coloring matter having a maximum absorption peak in a wavelength range from 550 to 600 nm.

An LED luminaire cover light diffuser according to a third aspect of the present invention is used for an illumination cover of an LED luminaire that illuminates a target object to enable the target object to be seen. The LED luminaire cover light diffuser includes base resin; light diffusing agent; and a coloring matter that at least partially absorbs light in a wavelength range from 500 to 600 nm. The LED luminaire cover light diffuser achieves spectral radiance at a wavelength of 450 nm that is higher than the spectral radiance at a wavelength of 550 nm, with the difference between the spectral radiance at the wavelength of 450 nm and the spectral radiance at the wavelength of 550 nm being within a range from 0.05 to 0.3 $W \cdot sr^{-1} m^{-2} nm^{-1}$, when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

The LED luminaire cover light diffuser achieves a relative value of spectral radiance at a wavelength of 450 nm preferably within a range from 1.60 to 13, and more preferably within a range from 1.60 to 11, with the spectral radiance at the wavelength of 550 nm defined as 1, when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

The LED luminaire cover light diffuser achieves a relative value of spectral radiance at a wavelength of 650 nm preferably within a range from 0.6 to 20, more preferably within a range from 0.6 to 18, and still more preferably within a range from 0.6 to 16, with the spectral radiance at the wavelength of 550 nm defined as 1, when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

The LED luminaire cover light diffuser achieves a value obtained by subtracting the spectral radiance at a wavelength of 550 nm from the spectral radiance at a wavelength of 450 nm preferably within a range from 0.14 to 0.3 $W \cdot sr^{-1}m^{-2}nm^{-1}$ and more preferably within a range from 0.16 to 0.3 $W \cdot sr^{-1}m^{-2}nm^{-1}$ when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

The LED luminaire cover light diffuser achieves a value obtained by subtracting the spectral radiance at a wavelength of 550 nm from the spectral radiance at a wavelength of 650 nm preferably within a range from -0.15 to 0.3 $W \cdot sr^{-1}m^{-2}nm^{-1}$, and more preferably within a range from -0.1 to 0.1 $W \cdot sr^{-1}m^{-2}nm^{-1}$, when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

For light at the wavelength of 550 nm, the LED luminaire cover light diffuser preferably has an absorption rate in a rage from 20 to 90%, and more preferably in a range from 25 to 85%. Thus, yellow light around 550 nm can be appropriately reduced, whereby a clear contrast can be achieved for a target object so that the color of the target object can be enhanced.

The LED luminaire cover light diffuser the shape and the thickness of which are not particularly limited as long as a condition for obtaining the effect of the present invention can be satisfied, is preferably a light diffusion plate (an LED luminaire cover light diffuser having a plate shape) with a thickness in a range from 0.5 to 5 mm. Due to the demand for lighter LED luminaires, the light diffusion plate preferably has a thickness (plate thickness) within a range from 0.7 to 3 mm.

The size and the shape of the LED luminaire cover light diffuser are not particularly limited and may be designed to conform with the size and the shape of a light emitting section (a portion other than the LED luminaire cover) of an LED luminaire such as an LED light bulb, a straight-tube LED luminaire, an LED desk stand, and an LED ceiling light.

The LED luminaire cover light diffuser may be a cylindrical or partially cylindrical LED luminaire cover light diffuser to be used for fluorescent tube type LED luminaire, or may be a light bulb shaped LED luminaire cover light diffuser.

The light bulb shaped LED luminaire cover light diffuser includes a semispherical LED luminaire cover light diffuser used in combination with a shade, a pear shaped LED luminaire cover light diffuser used for a bare light bulb, a LED luminaire cover light diffuser having a shape of a candle light to be used for chandelier light bulb, or the like.

The cylindrical or partially cylindrical LED luminaire cover light diffuser includes a cylindrical LED luminaire cover light diffuser that forms a circular column shaped LED luminaire together with an LED luminaire main body, and a half cylinder shaped LED luminaire cover light diffuser that forms a circular column shaped LED luminaire together with a half cylinder shaped LED luminaire main body.

The LED luminaire cover light diffuser may have a single-layer structure, but preferably has a multilayered structure including a first resin layer including base resin and light diffusing agent and a second resin layer including base resin and coloring matter that at least partially absorbs light in a wavelength range from 500 to 600 nm. The latter features less noticeable coloring by the coloring matter compared with the case of the single-layer structure, because the color of the second resin layer is seen through the first resin layer having a light diffusion property to be perceived as a whitish color. The multilayered structure more preferably further includes at least one another layer having a refractive index different from refractive indices of the first resin layer and the second resin layer (air layer for example) between the first resin layer and the second resin layer. Thus, the color of the second resin layer is seen through the other layer in which light is refracted between both surfaces, rendering coloring by the coloring matter even less noticeable.

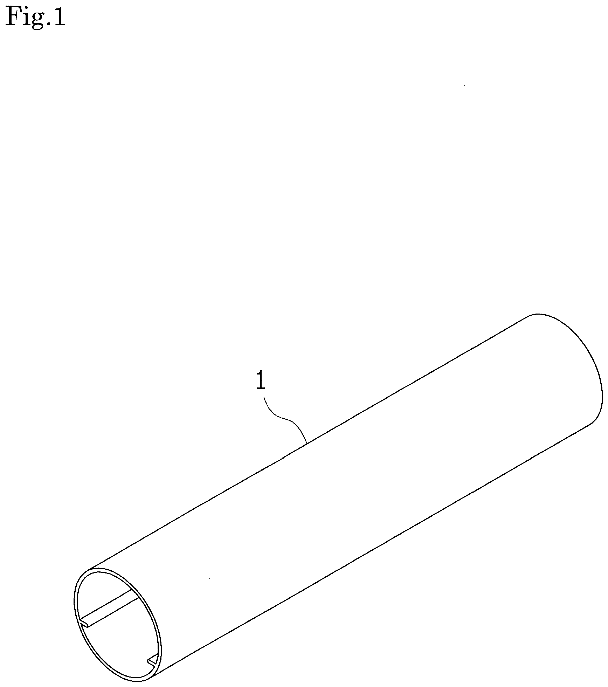

Fig. 1 illustrates one embodiment of an LED luminaire cover light diffuser with a single-layer structure. As illustrated in Fig. 1, this LED luminaire cover light diffuser is a LED luminaire cover light diffuser 1 having a single-layer structure and a cylindrical shape. The LED luminaire cover light diffuser 1 includes base resin, light diffusing agent, and a coloring matter that at least partially absorbs light in a wavelength range from 500 to 600 nm.

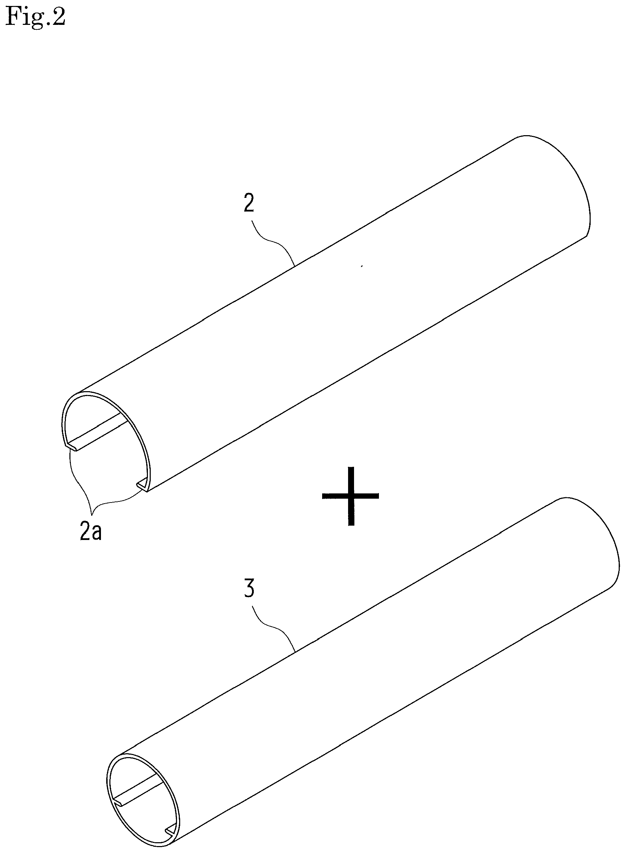

Fig. 2 illustrates one embodiment of an LED luminaire cover light diffuser having a three-layer structure. As illustrated in Fig. 2, this LED luminaire cover light diffuser includes a partially cylindrical first light diffusion unit (first resin layer) 2 and a cylindrical second light diffusion unit (second resin layer) 3. The first light diffusion unit 2 includes base resin and light diffusing agent, and is configured to cover the outer side of the second light diffusion unit 3. The first light diffusion unit 2 includes ridge shaped protrusions 2a extending in directions toward the center line of the partially cylindrical form. Thus, when the first light diffusion unit 2 is provided to cover the outer side of the second light diffusion unit 3, an air layer (at least one another layer having a refractive index different from refractive indices of the first resin layer and the second resin layer) is formed between the first light diffusion unit 2 and the second light diffusion unit 3. The second light diffusion unit 3 includes base resin and coloring matter that at least partially absorbs light in a wavelength range from 500 to 600 nm.

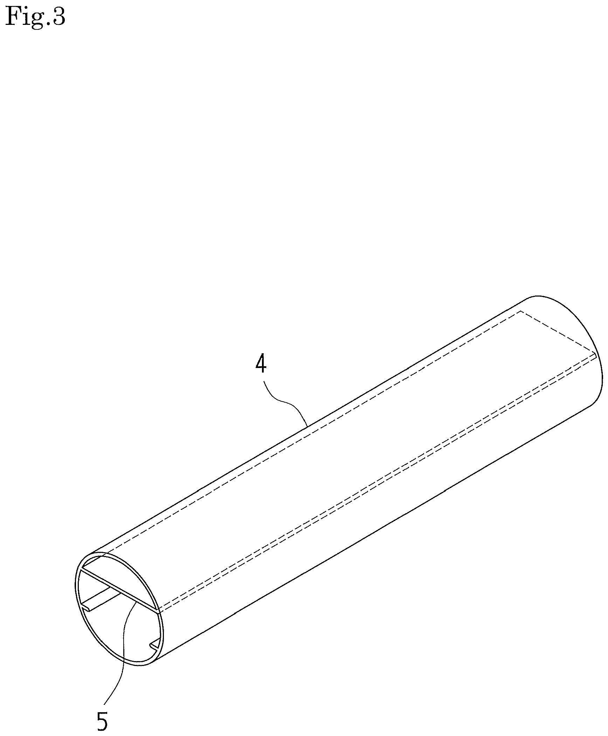

Fig. 3 illustrates another embodiment of an LED luminaire cover light diffuser having a three-layer structure.

As illustrated in Fig. 3, this LED luminaire cover light diffuser includes a cylindrical first light diffusion unit (first resin layer) 4 and a flat-plate-shaped second light diffusion unit (second resin layer) 5 inserted in the first light diffusion unit 4, and an air layer (at least one another layer having a refractive index different from refractive indices of the first resin layer and the second resin layer) is formed between the first light diffusion unit 4 and the second light diffusion unit 5. The first light diffusion unit 4 includes base resin and light diffusing agent. The second light diffusion unit 5 includes base resin and coloring matter that at least partially absorbs light in a wavelength range from 500 to 600 nm

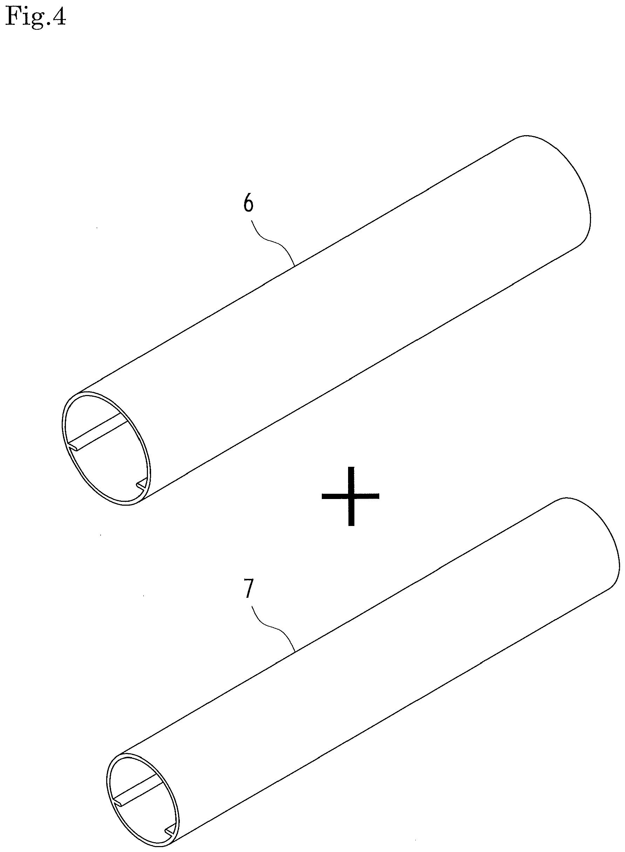

Fig. 4 illustrates a yet another embodiment of an LED luminaire cover light diffuser having a three-layer structure. As illustrated in Fig. 4, this LED luminaire cover light diffuser includes a cylindrical first light diffusion unit (first resin layer) 6 and a cylindrical second light diffusion unit (second resin layer) 7 having an outer diameter smaller than an inner diameter of the first light diffusion unit 6. The second light diffusion unit 7 is inserted in the first light diffusion unit in such a manner that an air layer (at least one another layer having a refractive index different from refractive indices of the first resin layer and the second resin layer) is formed between the first light diffusion unit 6 and the second light diffusion unit 7. The first light diffusion unit 6 includes base resin and light diffusing agent. The second light diffusion unit 7 includes base resin and coloring matter that at least partially absorbs light in a wavelength range from 500 to 600 nm. In the LED luminaire cover light diffuser with the three-layer structure in the embodiments described above, the air layer may be replaced with at least one another resin layer having a refractive index different from refractive indices of the first resin layer and the second resin layer.

[Coloring matter]

The coloring matter in the LED luminaire cover light diffusers according to the first and the third aspect of the present invention may be any coloring matter that at least partially absorbs light in a wavelength range from 500 to 600 nm, but is preferably a coloring matter having an absorption peak within the range from 500 to 600 nm, is preferably at least one of a red coloring matter and a violet coloring matter, and is particularly preferably is at least one of a red coloring matter having an absorption peak within the range from 500 to 600 nm and a violet coloring matter having an absorption peak within the range from 500 to 600 nm. The coloring matter in the LED luminaire cover light diffusers according to the first and the third aspect of the present invention is preferably a coloring matter having no absorption range in a wavelength range from 650 to 750 nm. The coloring matter in the LED luminaire cover light diffusers according to the first and the third aspect of the present invention is particularly preferably a coloring matter having a maximum absorption peak within a wavelength range from 550 to 600 nm.

The coloring matter in the LED luminaire cover light diffuser according to the second aspect of the present invention may be any coloring matter having a maximum absorption peak within a wavelength range from 550 to 600 nm, but is preferably at least one of a red coloring matter and a violet coloring matter.

The coloring matter may be dye or pigment, but preferably dye is used so that the LED luminaire cover light diffuser can have a higher light transmittance.

Examples of the coloring matter having the maximum absorption peak within the wavelength range from 550 to 600 nm include: red dye such as C.I.Solvent Red 111, C.I. Solvent Red 135, C.I.Solvent 207, C.I.solvent Red 52, C.I. Solvent Red 179, C.I.Solvent Red 168, C.I.Disperse Red 60, and C.I.Dispere Red 22; and violet dye such as C.I. Solvent Violet 36, C.I.Solvent Violet13, and C.I.Disperse Violet 28. These coloring matters are dye having no absorption range within the wavelength range from 650 to 750 nm. One type of such coloring matter is used or two or more types of such coloring matters may be used in combination.

The content of the coloring matter in the LED luminaire cover light diffusers according to the first and the third aspects of the present invention is preferably in a range from 0.1 to 10 ppm per weight. The content of the coloring matter in the LED luminaire cover light diffuser according to the second aspect of the present invention is in a range from 0.1 to 10 ppm per weight. The content of the coloring matter that is less than 0.1 ppm per weight might result in the LED luminaire cover light diffuser with insufficient reduction effect for yellow light around 550 nm. When the content of the coloring matter is more than 10 ppm per weight, the LED luminaire cover light diffuser might be colored with excessively high color density. As a result, the optical transmittance of the LED luminaire cover light diffuser might not be able to be maintained at a sufficient level.

Particularly preferably, in the LED luminaire cover light diffuser according to the first and third aspect of the present invention, the coloring matter has the maximum absorption peak within the wavelength range from 550 to 600 nm, the amount of the light diffusing agent is in a range from 0.1 to 5 parts by weight relative to 100 parts by weight of the base resin, and the amount of the coloring matter is within a range from 0.1 to 10 ppm per weight relative to 100 parts by weight of the base resin. With this configuration, the spectral radiance property required for the LED luminaire cover light diffusers according to the first and the third aspects of the present invention can be easily achieved.

[Light diffusing agent]

The light diffusing agent is preferably transparent particle. The transparent particle may be any particle having optical transmittance. The transparent particle may be particle having a uniform refractive index (particle made of a single material or core-shell particle including core and shell with the same refractive index for example), or particle with a plurality of parts with different refractive indices (core-shell particle including core and shell with different refractive indices for example).

The volume mean particle diameter of the transparent particle is preferably within a range from 0.3 to 10 $\mu$m, and is more preferably in a range from 0.5 to 5 $\mu$m. With the volume mean particle diameter of the transparent particle set to be 0.3 $\mu$m or larger, the LED luminaire cover light diffuser can have higher light diffusion property. With the volume mean particle diameter of the transparent particle set to be 10 $\mu$m or smaller, the LED luminaire cover light diffuser can have excellent optical transmittance.

Preferably, a coefficient of variation of the particle diameters of the transparent particles is equal to or smaller than 30%. If the coefficient of variation of the particle diameters of the transparent particles exceeds 30%, the number of transparent particle with a particle diameter within a range enabling the LED luminaire cover light diffuser to have excellent light diffusion property becomes small, and thus it becomes difficult to obtain a LED luminaire cover light diffuser with excellent light diffusion property.

Examples of the materials of the light diffusing agent (materials constituting the transparent particles) include synthetic resins such as crosslinked (meth)acrylic-based resins, crosslinked styrene-based resins, polyurethane-based resins, polyester-based resins, silicone-based resins, fluorine-based resins, and copolymers thereof; inorganic substances such as silica, calcium carbonate, and barium sulfate; and the like. Among them, preferable materials are synthetic resins; more preferable materials are crosslinked (meth)acrylic-based resins, crosslinked styrene-based resins, copolymers thereof (crosslinked (meth)acrylic-styrene copolymer), and silicone-based resins; and most preferable materials are silicone-based resins. In other words, the light diffusing agent preferably includes silicone-based resin particles. When the light diffusing agent includes silicone-based resin particles, the light diffusing agent preferably also includes (meth)acrylic-styrene copolymer particles. With this configuration, when the base resin is a polycarbonate-based resin, in particular, (meth)acrylic-styrene copolymer particles, which has a small difference in the refractive indices from the base resin, are used as the light diffusing agent, whereby the LED luminaire cover light diffuser is provided with an appropriate light diffusion property with dot-like appearance due to LED chips eliminated, and a reduction in the light transmittance of the LED luminaire cover light diffuser attributed to the addition of the light diffusing agent can be regulated. One of the above-described materials of the transparent particles may be used or two or more of such materials may be used in combination. As used herein, the term "(meth)acrylic" means methacrylic or acrylic. The term "(meth)acrylic-styrene copolymer" means a polymer of a monomer mixture containing a monofunctional (meth)acrylic-based monomer and a monofunctional styrene-based monomer.

In the case where the light diffusing agent contains a polymer of a vinyl-based monomer (a compound having at least one ethylenic unsaturated group) containing a crosslinkable monomer (a compound having two or more ethylenic unsaturated groups) such as a crosslinked (meth)acrylic-based resin, a crosslinked styrene-based resin, and a copolymer thereof, the polymer contains a structural unit deriving from the crosslinkable monomer preferably in an amount of 1 to 50% by weight, and more preferably in an amount of 5 to 30% by weight. If such range(s) is/are satisfied, a high-level three-dimensional network can be formed in the light diffusing agent, and it is eventually possible to provide an LED luminaire cover light diffuser having a superior light diffusion property.

Examples of the crosslinkable monomers include (meth)acrylate-based polyfunctional monomers such as allyl methacrylate, ethylene glycol di(meth)acrylate, diethylene glycol di(meth)acrylate, triethylene glycol di(meth)acrylate, nonaethylene glycol di(meth)acrylate, tetradecaethylene glycol di(meth)acrylate, decaethylene glycol di(meth)acrylate, pentadecaethylene glycol di(meth)acrylate, 1,3-butylene glycol di(meth)acrylate, 1,4-butanediol di(meth)acrylate, 1,6-hexanediol di(meth)acrylate, glycerin di(meth)acrylate, trimethylolpropane tri(meth)acrylate, pentaerythritol tetra(meth)acrylate, phthalate diethylene glycol di(meth)acrylate, caprolactone-modified dipentaerythritol hexa(meth)acrylate, caprolactone-modified neopentylglycol hydroxypivalate diacrylate, polyester acrylate, and urethane acrylate; and aromatic vinyl-based polyfunctional monomers such as divinyl benzene, divinyl naphthalene, and derivatives thereof. Two or more of these crosslinkable monomers may be used in combination. As used herein, the term "(meth)acrylate" means methacrylate or acrylate.

The crosslinked (meth)acrylic-based resin contains a monofunctional (meth)acrylic-based monomer. The monofunctional (meth)acrylic-based monomer is not particularly limited as far as being a compound having an acryloyloxy group or a methacryloyloxy group. Examples of the monofunctional (meth)acrylic-based monomer are acrylic acid, methyl acrylate, ethyl acrylate, n-butyl acrylate, isobutyl acrylate, dodecyl acrylate, stearyl acrylate, 2-ethylhexyl acrylate, tetrahydrofurfuryl acrylate, methacrylic acid, methyl methacrylate, ethyl methacrylate, n-propyl methacrylate, n-butyl methacrylate, isobutyl methacrylate, n-octyl methacrylate, dodecyl methacrylate, 2-ethylhexyl methacrylate, and stearyl methacrylate. One of these monofunctional (meth)acrylic-based monomers may be used or two or more of such monomers may be used in combination.

The styrene-based resin contains a monofunctional styrene-based monomer. The monofunctional styrene-based monomer is not particularly limited as far as being a styrene having an ethylenic unsaturated group. Examples of the styrene-based monomer are styrene, o-methylstyrene, m-methylstyrene, p-methylstyrene, and α-methylstyrene. One of these monofunctional styrene-based monomers may be used or two or more of such monomers may be used in combination. The copolymer of the crosslinked (meth)acrylic-based resin and the crosslinked styrene-based resin contains the above-mentioned monofunctional (meth)acrylic-based monomer and the above-mentioned monofunctional styrene-based monomer.

The light diffusing agent may have any refractive index different from a refractive index of the base resin. Preferably, the difference between the light diffusing agent and the base resin in the refractive indices is within a range from 0.01 to 0.2. More preferably, the difference between the light diffusing agent and the base resin in the refractive indices is within a range from 0.02 to 0.1.

The shape of the transparent particle is not particularly limited, but is preferably a spherical shape.

The light diffusing agent may be uniformly dispersed in the base resin over the entire LED luminaire cover light diffuser, and may be provided as a layer of the light diffusing agent on a light incident surface side and/or a light output surface side of the base resin.

The content of the light diffusing agent in the LED luminaire cover light diffuser according to the first and the third aspects of the present invention is not particularly limited as long as a condition for obtaining the effect of the present invention can be satisfied, but is preferably within a range from 0.5 to 5.0 parts by weight relative to 100 parts by weight of the base resin. The content of the light diffusing agent in the LED luminaire cover light diffuser according to the second aspect of the present invention is within a range from 0.5 to 5.0 parts by weight relative to 100 parts by weight of the base resin. With the content of the light diffusing agent set to be equal to or larger than 0.5 parts by weight, the LED luminaire cover light diffuser can have even higher light diffusion property. With the content of the light diffusing agent set to be equal to or smaller than 5.0 parts by weight, the LED luminaire cover light diffuser can have excellent optical transmittance.

[Base resin]

The base resin is not particularly limited as long as the base resin has sufficient optical transmittance for providing illumination. Examples of the base resin include polycarbonate-based resins; cellulose derivatives such as acetylcellulose, nitrocellulose, cellulose acetate butyrate, ethylcellulose, and methylcellulose; a homopolymer or copolymer of vinyl acetate, a homopolymer or copolymer of vinyl chloride, a homopolymer or copolymer of vinylidene chloride; acetal-based resins such as polyvinyl formal and polyvinyl butyral; (meth)acrylic-based resins such as acrylic resins (polyacrylic acid esters) and copolymer resins thereof, and methacrylic resins (polymethacrylic acid esters) and copolymer resins thereof; polystyrene resins; polyamide resins; and linear polyester resins such as polyethylene terephthalate resins (hereinafter abbreviated as "PET resins"). Among these resins, polycarbonate-based resins, (meth)acrylic resins, and PET resins are preferable in terms of transparency, thermal resistance, and impact strength. Above all, polycarbonate-based resins are particularly preferred for their excellent thermal resistance and impact resistance.

Examples of a method of molding the LED luminaire cover light diffuser include, but are not particularly limited to, sheet molding by T-die extrusion molding, molding into a cylindrical or a partially cylindrical shape by profile extrusion molding, molding into a light bulb shape by injection molding or injection blow molding, molding into a disc shape by sheet forming followed by vacuum molding or pressure molding, or molding into other like shapes by other like processes.

[Use of LED luminaire cover light diffuser]

The LED luminaire cover light diffuser can be used for an LED luminaire cover for an LED luminaire using a white LED as a light source. With this configuration, an LED luminaire that can enhance the color tone of the target object to enable the target object to be vividly seen can be implemented at a low cost. In this application, "white LED" is generally defined as follows. Specifically, the white LED is an LED that provides white light as a mixture of two or more colors of light. A configuration to implement the white LED that is most widely employed is a blue LED + phosphor configuration, in which light from a blue LED passes through phosphors to be emitted as white light. The white LEDs implemented with other configurations include a white LED obtained as a combination of LED chips corresponding to three colors of red, green, and blue and a white LED obtained as a combination of a blue LED, a red fluorescent agent, and a green fluorescent agent.

The LED luminaire cover light diffuser can be suitably used for an LED luminaire cover for an LED luminaire that illuminates a food product (in particular, fresh food, for example, leaf vegetables and other vegetables, beef and other meat, fresh fish) or display items (for examples, exhibits in galleries and exhibits in museums). The LED luminaire cover light diffuser can be also suitably used for other products, for examples, cosmetics displayed in a cosmetic counter and fresh flowers.

[LED luminaire]

The LED luminaire according to the first aspect of the present invention includes the LED luminaire cover light diffuser according to the first, the second, or the third aspect of the present invention. The LED luminaire according to the first aspect of the present invention may include a white LED or a high-color LED as the light source. When the LED luminaire according to the first aspect of the present invention includes the white LED as the light source, the LED luminaire that can enhance the color tone of the target object so that the target object can be vividly seen can be implemented at a low cost. When the LED luminaire according to the first aspect of the present invention includes the high-color LED as the light source, the LED luminaire that can further enhance the color tone of the target object so that the target object can be even more vividly seen can be implemented.

The LED luminaire according to the second aspect of the present invention is an LED luminaire that illuminates the target object so that the target object can be seen. The LED luminaire includes an LED, base resin, light diffusing agent, and a coloring matter that at least partially absorbs light in a wavelength range from 500 to 600 nm. In the LED luminaire, the relative value of the spectral radiance at the wavelength of 450 nm is within a range from 1.60 to 15, with the spectral radiance at the wavelength of 550 nm defined as 1. With this configuration, the LED luminaire that enhances the color tone of the target object so that the target object can be vividly seen can be implemented.

The LED luminaire according to the third aspect of the present invention is an LED luminaire that illuminates the target object so that the target object can be seen. The LED luminaire includes base resin, light diffusing agent, and a coloring matter that at least partially absorbs light in a wavelength range from 500 to 600 nm. The spectral radiance at the wavelength of 450 nm is higher than the spectral radiance at the wavelength of 550 nm, with the difference between the spectral radiance at the wavelength of 450 nm and the spectral radiance at the wavelength of 550 nm being within a range from 0.05 to 0.3 $W \cdot sr^{-1} m^{-2} nm^{-1}$.

The LED luminaire according to each of the second and the third aspects of the present invention may have the same configuration as that of the LED luminaire according to the first aspect of the present invention. However, the LED luminaire cover light diffuser of the LED luminaire according to each of the second and the third aspects of the present invention may not have spectral radiance characteristics achieved by the LED luminaire cover light diffuser according to the first aspect of the present invention described above.

[Examples]

The present invention is described below based on Examples and Comparative Examples, but the present invention is not limited to these. First of all, in Examples and Comparative Examples, a description is given on measurement methods for the volume mean particle diameter and the coefficient of variation of particle diameters of the transparent particles, for the spectral radiance of the LED luminaire, and for the absorption rate of the LED luminaire cover light diffuser for the light at the wavelength of 550 nm.

[Measurement method for volume mean particle diameters and coefficient of variation of particle diameters of transparent particles]

The volume mean particle diameter and a coefficient of variation of particle diameters of the transparent particles used as the light diffusing agent are measured with a Coulter method as described below.

The volume mean particle diameters of the transparent particles are measured with Coulter Multisizer™ 3 (a measurement device manufactured by Beckman Coulter, Inc.). The measurement is performed by using an aperture calibrated in accordance with the user's manual for Multisizer™ 3 published by Beckman Coulter, Inc.

The aperture used for the measurement is selected as appropriate in accordance with the size of the transparent particle to be measured. The current (aperture current) and gain are set as appropriate in accordance with the size of the aperture selected. For example, when the aperture with the size of 50 $\mu$m is selected, the current (aperture current) is set to -800 and gain is set to be 4.

A measurement sample used is obtained as a dispersion obtained with 0.1g (that is, 0.1 percent by weight) of transparent particle dispersed in 10 ml of nonionic surfactant aqueous solution using a touch mixer ("TOUCHMIXER MT-31" manufactured by YAMATO Scientific Co., LTD.) and an ultrasonic cleaner ("ULTRASONIC CLEANER VS-150" manufactured by VELVO-CLEAR Inc.). During the measurement, the content in a beaker is lightly stirred as long as air bubbles do not enter thereinto, and the measurement is terminated at the point when 100 thousand transparent particles are measured. The volume mean particle diameter of the transparent particles is an arithmetic mean in a volume-based particle size distribution of the 100 thousand transparent particles.

The coefficient of variation (CV value) of the particle diameters of the transparent particles is calculated with

the following formula:

$$\text{Coefficient of variation of particle diameters of transparent particles} =$$
$$\text{(standard deviation of volume-based particle size distribution of transparent}$$
$$\text{particles/volume mean particle diameter of the transparent particles)} \times 100$$

[Measurement method for spectral radiance of LED luminaire]

The spectral radiance of the LED luminaire was measured as follows. The LED luminaire placed in a darkroom set to be at a temperature of 25 degrees was turned ON to emit light for 20 minutes. Then, the spectral radiance was measured by using a spectral irradiance meter at a position 1 m immediately below a light emitting section of the LED luminaire. Then, the spectral radiance was calculated based on a method defined in the JIS C 7550 "Photobiological safety of lamps and lamp systems"

[Measurement method for spectral radiance of LED luminaire cover light diffuser combined with white LED]

In the present invention, the spectral radiance was measured for a configuration where the white LED is used as the measurement light source and the LED luminaire cover light diffuser is provided to cover the white LED in the following manner. Specifically, the spectral radiance is measured with the measurement method in a configuration using the white LED having the first peak of the spectral radiance in the wavelength range from 440 to 460 nm and having the second peak of the spectral radiance in the wavelength range from 545 to 575 nm.

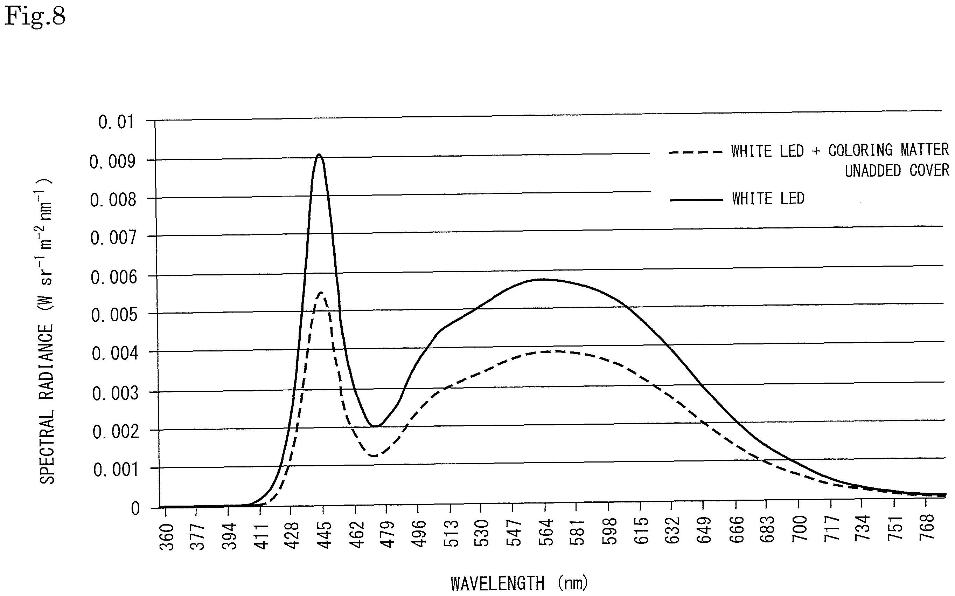

An example of the measurement light source that can be used includes a main body (a portion without the cover) of a commercially available 40 W straight tube LED luminaire (model "FWK40NSMSP5-72V" manufactured by ELEVAM corporation) including the white LED. The solid line in Fig. 8 represents a result of measuring the spectral radiance of the measurement light source (the main body of the LED luminaire) of the Example in the manner same as that in the measurement method described above except that the measurement position is changed to a position 2.0 m immediately below the light emitting section of the LED luminaire. Even when the measurement position is changed from the position 1 m immediately below the light emitting section to the position 2.0 m immediately below the light emitting section, the relative value of the spectral radiance at the wavelength of 450 nm with the spectral radiance at the wavelength of 550 nm defined as 1, and the relative value of the spectral radiance at the wavelength of 450 nm with the spectral radiance at the wavelength of 550 nm defined as 1 do not substantially change.

As the measurement light source, a white LED is preferably used having the relative value of the spectral radiance at the wavelength of 450 nm within a range from 1.30 to 1.55 with the spectral radiance at the wavelength of 550 nm defined as 1, and the relative value of the spectral radiance at the wavelength of 650 nm within a range from 0.30 to 0.55 with the spectral radiance at the wavelength of 550 nm defined as 1.

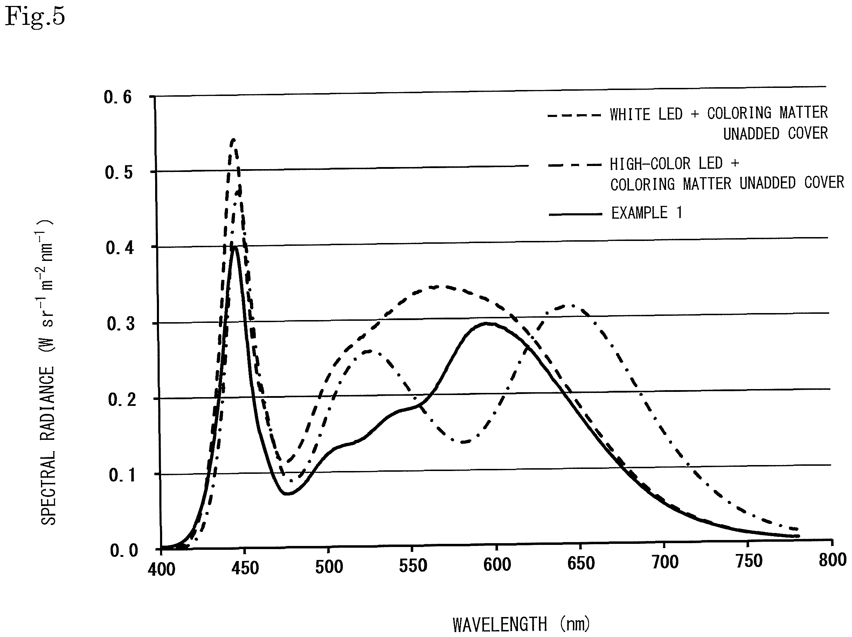

A broken line in Fig. 8 represents a result of measuring the spectral radiance of a LED luminaire (LED luminaire according to Comparative Example 1) with an LED luminaire cover light diffuser including no coloring matter (written as "coloring matter unadded cover" in Figs. 5 to 8) covering the white LED. As can be seen in Fig. 8, the spectrum waveform of the spectral radiance does not substantially change depending on whether the LED luminaire cover light diffuser exists.

[Measurement method for absorption rate of LED luminaire cover light diffuser for light at wavelength of 550 nm]

Based on spectral radiance R at the wavelength of 550 nm of the LED luminaire with the LED luminaire cover attached measured by the method described above and spectral radiance Ro at the wavelength of 550 nm of the LED luminaire (LED only) with the LED luminaire cover detached measured by the method described above, an absorption rate A(%) of LED luminaire cover light diffuser for light at the wavelength of 550 nm is calculated with the following formula:

$$A = 100 \times (R_0 - R)/R_0$$

[Evaluation method for light diffusion property of LED luminaire]

The light diffusion property is evaluated with the following evaluation criteria based on visual confirmation on the LED luminaire:

A : Dot-like appearance due to LED chip not confirmed.
C: Dot-like appearance due to LED chip clearly confirmed.

[Evaluation method for meat color enhancement by LED luminaire]

Meat (beef, pork) illuminated by an LED luminaire of Example/Comparative Example and meat (beef, pork) illuminated by a white LED (blank) are placed side by side, and colors of the meat are visually checked, and meat color enhancement was evaluated based on the following evaluation criteria.

A: The red color of a lean part is enhanced from that in the case of the blank, whereby contrast from a fat portion can be clearly seen.
B: The fat portion also is slightly colored in red, and thus the contrast between the lean portion and the fat portion is smaller than that in the case of A.
C: The enhancement of the color tone from the case of the blank cannot be confirmed.

[Evaluation method for vegetable color enhancement by LED luminaire]

Colors of vegetable (cabbage, tomato, green pepper, cucumber) illuminated by an LED luminaire of Example/Comparative Example and colors of vegetable (cabbage, tomato, green pepper, cucumber) illuminated by a white LED (blank) are visually checked, and vegetable color enhancement was evaluated based on the following evaluation criteria.

A: Contrast among red, blue, and green can be more clearly confirmed compared with the case of blank.
B: Difference in contrast among red, blue, and green is smaller than that in A.
C: Difference in contrast from blank cannot be confirmed.

[Example 1]

Here, 0.8 parts by weight of silicone-based resin particles (product name "GANZPEARL (registered trademark) SI-020" manufactured by AICA kogyo Co., Ltd., volume mean particle diameter: 2.1 μm, coefficient of variation of particle diameters: 26.6%) as one type of transparent particles serving as the light diffusing agent, "Red1350 ("FS Red 1350" manufactured by Arimoto Chemical Co. Ltd., abbreviated as R in Table 1)" in an amount of 5 ppm per weight (written as "ppm" in Table 1) relative to the entire mixture described later to serve as the coloring matter that at least partially absorbs light in a wavelength range from 500 to 600 nm and as the coloring matter having the maximum absorption peak in the wavelength range from 550 to 600 nm, and 100 parts by weight of polycarbonate-based resin (product name "Iupilon (registered trademark) S2000UR" manufactured by Mitsubishi Engineering-Plastics Corporation) serving as the base resin were each measured and were mixed in a Henschel mixer for 15 minutes, whereby the mixture was obtained. This mixture was extruded with a single screw extruder (model "R50" manufactured by Hoshi Plastic Co., Ltd.) under conditions of temperature 250 to 280 °C and a discharge amount of 10 to 25 kg/h, cooled by water, and then was cut by a pelletizer, whereby a LED luminaire cover light diffuser having a pellet shape was obtained.
Then, a cylindrical LED luminaire cover light diffuser (LED luminaire cover having the single-layer structure) with a thickness of 1 mm was prepared by an extrusion process by using the LED luminaire cover light diffuser having the pellet shape thus obtained. The cylindrical LED luminaire cover light diffuser was attached to the main body (portion without the cover) of a commercially available 40 W straight tube LED luminaire (model "FWK40NSMSP5-72V" manufactured by ELEVAM corporation) including the white LED, whereby an LED luminaire was prepared.
Fig. 5 and Table 1 illustrate a result of measuring the spectral radiance of the LED luminaire thus obtained (a result of measuring the spectral radiance with the white LED used as the measurement light source and the LED luminaire cover light diffuser provided to cover the white LED).
Fig. 5 also illustrates a result of measuring the spectral radiance of the LED luminaire (LED luminaire of Comparative Example 1) obtained by attaching an LED luminaire cover light diffuser including no coloring matter to the main body of the LED luminaire used in this Example (spectral radiance of "white LED + coloring matter unadded cover"). Furthermore, Fig. 5 illustrates a result of measuring the spectral radiance of an LED luminaire obtained by attaching the LED luminaire cover light diffuser of Comparative Example 1 including no coloring matter to a main body of an LED luminaire used in Example 7 described later (spectral radiance of "high-color LED + coloring matter unadded cover").
In Table 1, a value in a column "wavelength of 450 nm/550 nm" of the spectral radiance is a relative value of the spectral radiance at the wavelength of 450 nm with the spectral radiance at the wavelength of 550 nm defined as 1. A value in a column "wavelength of 650 nm/550 nm" of the spectral radiance is a relative value of the spectral radiance at the wavelength of 650 nm with the spectral radiance at the wavelength of 550 nm defined as 1. A value in a column "wavelength of 450-550 nm" of the spectral radiance in Table 1 is a value obtained by subtracting the spectral radiance at the wavelength of 550 nm from the spectral radiance at the wavelength of 450 nm. A value in a column "wavelength of 550-650 nm" of the spectral radiance in Table 1 is a value obtained by subtracting the spectral radiance at the wavelength of 650 nm from the spectral radiance at the wavelength of 550 nm. Table 1 also illustrates a result of measuring the absorption rate of the LED luminaire cover of this Example for the light at the wavelength of 550 nm.

The LED luminaire obtained has the relative value of the spectral radiance at the wavelength of 450 nm being 1.95 with the spectral radiance at the wavelength of 550 nm defined as 1 and the relative value of the spectral radiance at the wavelength of 650 nm being 0.95 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 2]

A cylindrical LED luminaire cover light diffuser was prepared in the manner same as that described in Example 1 except that "FS Violet 1803" (manufactured by Arimoto Chemical Co. Ltd., C.I. Solvent Violet 36, anthraquinone violet dye, abbreviated as V in Table 1) was used instead of the "Red1350", as the coloring matter that at least partially absorbs light in a wavelength range from 500 to 600 nm and as the coloring matter having the maximum absorption peak in the wavelength range from 550 to 600 nm. An LED luminaire was prepared in the manner same as that described in Example 1 except that this cylindrical LED luminaire cover light diffuser was used.

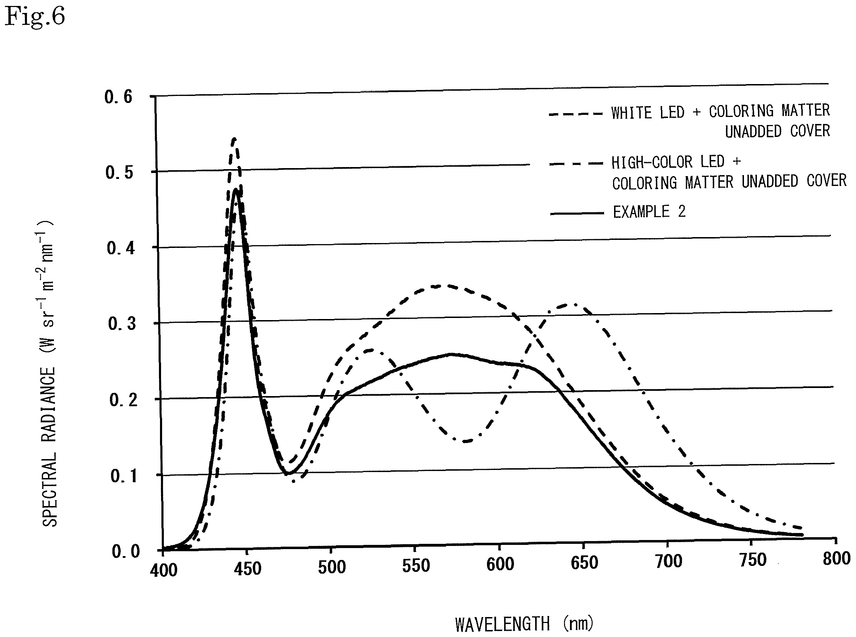

Fig. 6 and Table 1 illustrate a result of measuring the spectral radiance of the LED luminaire thus obtained. Fig. 6 also illustrates a result of measuring the spectral radiance of the LED luminaire (LED luminaire of Comparative Example 1) obtained by attaching an LED luminaire cover light diffuser including no coloring matter to the main body of the LED luminaire used in this Example (spectral radiance of "white LED + coloring matter unadded cover"). Furthermore, Fig. 6 illustrates a result of measuring the spectral radiance of an LED luminaire obtained by attaching the LED luminaire cover light diffuser of Comparative Example 1 including no coloring matter to a main body of an LED luminaire used in Example 7 described later (spectral radiance of "high-color LED + coloring matter unadded cover"). Table 1 also illustrates a result of measuring the absorption rate of the LED luminaire cover of this Example for the light at the wavelength of 550 nm.

The LED luminaire obtained has the relative value of the spectral radiance at the wavelength of 450 nm being 1.81 with the spectral radiance at the wavelength of 550 nm defined as 1 and the relative value of the spectral radiance at the wavelength of 650 nm being 0.69 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 3]

A cylindrical LED luminaire cover light diffuser was prepared in the manner same as that described in Example 1 except that a combination of "Red1350" in an amount that is 2.5 ppm per weight relative to the entire mixture and "FS Violet 1803" in an amount that is 2.5 ppm per weight relative to the entire mixture is used instead of "Red1350" in an amount that is 5 ppm per weight relative to the entire mixture, as the coloring matter that at least partially absorbs light in a wavelength range from 500 to 600 nm and as the coloring matter having the maximum absorption peak in the wavelength range from 550 to 600 nm. An LED luminaire was prepared in the manner same as that described in Example 1 except that this cylindrical LED luminaire cover light diffuser was used.

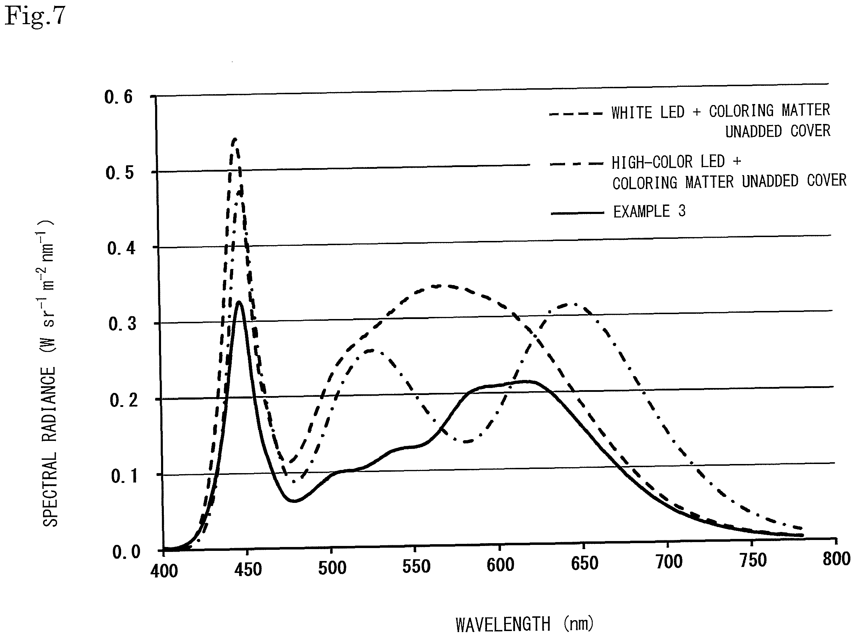

Fig. 7 and Table 1 illustrate a result of measuring the spectral radiance of the LED luminaire thus obtained. Fig. 7 also illustrates a result of measuring the spectral radiance of the LED luminaire (LED luminaire of Comparative Example 1) obtained by attaching an LED luminaire cover light diffuser including no coloring matter to the main body of the LED luminaire used in this Example (spectral radiance of "white LED + coloring matter unadded cover"). Furthermore, Fig. 7 illustrates a result of measuring the spectral radiance of an LED luminaire obtained by attaching the LED luminaire cover light diffuser of Comparative Example 1 including no coloring matter to a main body of an LED luminaire used in Example 7 described later (spectral radiance of "high-color LED + coloring matter unadded cover"). Table 1 also illustrates a result of measuring the absorption rate of the LED luminaire cover of this Example for the light at the wavelength of 550 nm.

The LED luminaire obtained has the relative value of the spectral radiance at the wavelength of 450 nm being 2.36 with the spectral radiance at the wavelength of 550 nm defined as 1 and the relative value of the spectral radiance at the wavelength of 650 nm being 1.19 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 4]

Here, "Red1350" in an amount of 5 ppm per weight relative to the entire mixture described later to serve as the coloring matter that at least partially absorbs light in a wavelength range from 500 to 600 nm and as the coloring matter having the maximum absorption peak in the wavelength range from 550 to 600 nm, and 100 parts by weight of polycarbonate-based resin (product name "Iupilon (registered trademark) S2000UR" manufactured by Mitsubishi Engineering-Plastics Corporation) serving as the base resin were each measured and were mixed in a Henschel mixer for 15 minutes, whereby the mixture was obtained. This mixture was extruded with a single screw extruder (model "R50" manufactured by Hoshi Plastic Co., Ltd.) under conditions of temperature 250 to 280 °C and a discharge amount of 10 to 25 kg/h, cooled by water, and then was cut by a pelletizer, whereby a LED luminaire cover light diffuser having a pellet shape was obtained. Then, the cylindrical second light diffusion unit 3 (a thickness of 1 mm) including the coloring matter as illustrated in Fig. 2 was prepared by an extrusion process by using the LED luminaire cover light diffuser having the pellet shape thus obtained.

Similarly, 0.8 parts by weight of silicone-based resin particles (product name "GANZPEARL (registered trademark) SI-020" manufactured by AICA kogyo Co., Ltd., volume mean particle diameter: 2.1 μm, coefficient of variation of particle diameters: 26.6%) as one type of transparent particles serving as the light diffusing agent and 100 parts by weight of polycarbonate-based resin (product name "Iupilon (registered trademark) S2000UR" manufactured by Mitsubishi Engineering-Plastics Corporation) serving as the base resin were each measured and were mixed in a Henschel mixer for 15 minutes, whereby the mixture was obtained. This mixture was extruded with a single screw extruder (model "R50" manufactured by Hoshi Plastic Co., Ltd.) under conditions of temperature 250 to 280 °C and a discharge amount of 10 to 25 kg/h, cooled by water, and then was cut by a pelletizer, whereby a LED luminaire cover light diffuser having a pellet shape was obtained. Then, the partially cylindrical first light diffusion unit 2 (a thickness of 1 mm) including the light diffusing agent as illustrated in Fig. 2 was prepared by an extrusion process by using the LED luminaire cover light diffuser having the pellet shape thus obtained.

An LED luminaire was prepared by attaching the cylindrical second light diffusion unit 3 (second resin layer) including the coloring matter described above and the partially cylindrical first light diffusion unit 2 (first resin layer) including the light diffusing agent described above in this order to the main body (portion without the cover) of a commercially available 40 W straight tube LED luminaire (model "FWK40NSMSP5-72V" manufactured by ELEVAM corporation). The air layer (third layer) was formed between the second light diffusion unit 3 and the first light diffusion unit 2. Thus, the LED luminaire thus prepared has the LED luminaire cover including the cylindrical second light diffusion unit (second resin layer) 3 including the coloring matter, the air layer (another layer), and the partially cylindrical first light diffusion unit (first resin layer) 2 including the light diffusing agent to have a three-layer structure.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 1.95 with the spectral radiance at the wavelength of 550 nm defined as 1 and the relative value of the spectral radiance at the wavelength of 650 nm being 0.95 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 5]

Two cylindrical LED luminaire cover light diffusers were prepared in the manner same as that described in Example 4 except that "FS Violet 1803" was used instead of "Red1350", as the coloring matter that at least partially absorbs light in a wavelength range from 500 to 600 nm and as the coloring matter having the maximum absorption peak in the wavelength range from 550 to 600 nm. An LED luminaire including a LED luminaire cover having a three-layer structure was prepared in the manner same as that described in Example 4 except that these cylindrical LED luminaire cover light diffusers were used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 1.81 with the spectral radiance at the wavelength of 550 nm defined as 1 and the relative value of the spectral radiance at the wavelength of 650 nm being 0.69 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 6]

Two cylindrical LED luminaire cover light diffusers were prepared in the manner same as that described in Example 4 except that a combination of "Red1350" in an amount that is 2.5 ppm per weight relative to the entire mixture and "FS Violet 1803" in an amount that is 2.5 ppm per weight relative to the entire mixture is used instead of "Red1350" in an amount that is 5 ppm per weight relative to the entire mixture, as the coloring matter that at least partially absorbs light in a wavelength range from 500 to 600 nm and as the coloring matter having the maximum absorption peak in the wavelength range from 550 to 600 nm. An LED luminaire including a LED luminaire cover having a three-layer structure was prepared in the manner same as that described in Example 4 except that these cylindrical LED luminaire cover light diffusers were used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 2.36 with the spectral radiance at the wavelength of 550 nm defined as 1 and the relative value of the spectral radiance at the wavelength of 650 nm being 1.19 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 7]

The cylindrical LED luminaire cover light diffuser prepared in the manner same as that described in Example 1 was used, and an LED luminaire was prepared in the manner same as that described in Example 1 except that a main body of a commercially available 40 W straight tube LED luminaire (model "NFSW757D-V1M6" manufactured by NICHIA CORPORATION) including high-color LEDs was used instead of the main body of the commercially available 40 W straight tube LED luminaire including the white LED.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 3.82 with the spectral radiance at the wavelength of 550 nm defined as 1 and the relative value of the spectral radiance at the wavelength of 650 nm being 5.38 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 8]

The cylindrical LED luminaire cover light diffuser prepared in the manner same as that described in Example 2 was used, and an LED luminaire was prepared in the manner same as that described in Example 2 except that a main body of a commercially available 40 W straight tube LED luminaire (model "NFSW757D-V1M6" manufactured by NICHIA CORPORATION) including high-color LEDs was used instead of the main body of the commercially available 40 W straight tube LED luminaire including the white LED.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 3.51 with the spectral radiance at the wavelength of 550 nm defined as 1 and the relative value of the spectral radiance at the wavelength of 650 nm being 4.09 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 9]

The cylindrical LED luminaire cover light diffuser prepared in the manner same as that described in Example 3 was used, and an LED luminaire was prepared in the manner same as that described in Example 3 except that a main body of a commercially available 40 W straight tube LED luminaire (model "NFSW757D-V1M6" manufactured by NICHIA CORPORATION) including high-color LEDs was used instead of the main body of the commercially available 40 W straight tube LED luminaire including the white LED.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 4.19 with the spectral radiance at the wavelength of 550 nm defined as 1 and the relative value of the spectral radiance at the wavelength of 650 nm being 6.39 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 10]

Two cylindrical LED luminaire cover light diffuser prepared in the manner same as that described in Example 4 was used, and an LED luminaire was prepared in the manner same as that described in Example 4 except that a main body of a commercially available 40 W straight tube LED luminaire (model "NFSW757D-V1M6" manufactured by NICHIA CORPORATION) including high-color LEDs was used instead of the main body of the commercially available 40 W straight tube LED luminaire including the white LED.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 3.82 with the spectral radiance at the wavelength of 550 nm defined as 1 and the relative value of the spectral radiance at the wavelength of 650 nm being 5.38 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 11]

Two cylindrical LED luminaire cover light diffuser prepared in the manner same as that described in Example 5 was used, and an LED luminaire was prepared in the manner same as that described in Example 5 except that a main body of a commercially available 40 W straight tube LED luminaire (model "NFSW757D-V1M6" manufactured by NICHIA CORPORATION) including high-color LEDs was used instead of the main body of the commercially available 40 W straight tube LED luminaire including the white LED.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 3.51 with the spectral radiance at the wavelength of 550 nm defined as 1 and the relative value of the spectral radiance at the wavelength of 650 nm being 4.09 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 12]

Two cylindrical LED luminaire cover light diffuser prepared in the manner same as that described in Example 6 was used, and an LED luminaire was prepared in the manner same as that described in Example 6 except that a main body of a commercially available 40 W straight tube LED luminaire (model "NFSW757D-V1M6" manufactured by NICHIA CORPORATION) including high-color LEDs was used instead of the main body of the commercially available 40 W straight tube LED luminaire including the white LED.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 4.19 with the spectral radiance at the wavelength of 550 nm defined as 1 and the relative value of the spectral radiance at the wavelength of 650 nm being 6.39 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 13]

A cylindrical LED luminaire cover light diffuser was prepared in the manner same as that described in Example 1 except that the concentration of the coloring matter in the mixture was changed to 0.5 ppm per weight. An LED luminaire was prepared in the manner same as that described in Example 1 except that this cylindrical LED luminaire cover light diffuser was used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 1.88 with the spectral radiance at the wavelength of 550 nm defined as 1 and the relative value of the spectral radiance at the wavelength of 650 nm being 0.72 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 14]

A cylindrical LED luminaire cover light diffuser was prepared in the manner same as that described in Example 1 except that the concentration of the coloring matter in the mixture was changed to 10 ppm per weight. An LED luminaire was prepared in the manner same as that described in Example 1 except that this cylindrical LED luminaire cover light diffuser was used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 2.48 with the spectral radiance at the wavelength of 550 nm defined as 1 and the relative value of the spectral radiance at the wavelength of 650 nm being 1.33 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 15]

A cylindrical LED luminaire cover light diffuser was prepared in the manner same as that described in Example 7 except that the concentration of the coloring matter in the mixture was changed to 0.5 ppm per weight. An LED luminaire was prepared in the manner same as that described in Example 1 except that this cylindrical LED luminaire cover light diffuser was used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 2.92 with the spectral radiance at the wavelength of 550 nm defined as 1 and the relative value of the spectral radiance at the wavelength of 650 nm being 3.75 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 16]

A cylindrical LED luminaire cover light diffuser was prepared in the manner same as that described in Example 7 except that the concentration of the coloring matter in the mixture was changed to 10 ppm per weight. An LED luminaire was prepared in the manner same as that described in Example 1 except that this cylindrical LED luminaire cover light diffuser was used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 4.35 with the spectral radiance at the wavelength of 550 nm defined as 1 and the relative value of the spectral radiance at the wavelength of 650 nm being 5.80 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 17]

A first cylindrical LED luminaire cover light diffuser was prepared in the manner same as that described in Example 1 except that the concentration of the coloring matter in the mixture was changed to 2.5 ppm per weight. A second cylindrical LED luminaire cover light diffuser was prepared in the manner same as that described in Example 2 except that the concentration of the coloring matter in the mixture was changed to 2.5 ppm per weight and that extruding was performed in such a manner that the second cylindrical LED luminaire cover light diffuser is prepared to have an inner diameter that is slightly larger than the outer diameter of the first cylindrical LED luminaire cover light diffuser.

An LED luminaire was prepared in the manner same as that described in Example 4 except that a member obtained by layering the second cylindrical LED luminaire cover light diffuser on the outer side of the first cylindrical LED luminaire cover light diffuser was used instead of the cylindrical second light diffusion unit 3. An air layer was formed between the first cylindrical LED luminaire cover light diffuser and the second cylindrical LED luminaire cover light diffuser, and between the second cylindrical LED luminaire cover light diffuser and the partially cylindrical first light diffusion unit 2. Thus, the LED luminaire has an LED luminaire cover including the first cylindrical LED luminaire cover light diffuser including a red coloring matter, a first air layer, the second cylindrical LED luminaire cover light diffuser including a violet coloring matter, a second air layer, and the partially cylindrical first light diffusion unit (first resin layer) 2 including the light diffusing agent, to have a five-layer structure.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 2.66 with the spectral radiance at the wavelength of 550 nm defined as 1 and the relative value of the spectral radiance at the wavelength of 650 nm being 1.44 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 18]

A cylindrical LED luminaire cover light diffuser was prepared in the manner same as that described in Example 1 except that the amount of the silicone-based resin particles used as the light diffusing agent was changed to 0.5 parts by weight. An LED luminaire was prepared in the manner same as that described in Example 1 except that this cylindrical LED luminaire cover light diffuser was used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 1.79 with the spectral radiance at the wavelength of 550 nm defined as 1 and the relative value of the spectral radiance at the wavelength of 650 nm being 1.00 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Example 19]

A cylindrical LED luminaire cover light diffuser was prepared in the manner same as that described in Example 1 except that the amount of the silicone-based resin particles used as the light diffusing agent was changed to 3.0 parts by weight. An LED luminaire was prepared in the manner same as that described in Example 1 except that this cylindrical LED luminaire cover light diffuser was used.

Table 1 illustrates a result of measuring the spectral radiance for the LED luminaire obtained, as well as a result of measuring the absorption rate of the LED luminaire cover for the light at the wavelength of 550 nm. The LED luminaire obtained has the relative value of the spectral radiance at the wavelength of 450 nm being 1.78 with the spectral radiance at the wavelength of 550 nm defined as 1 and the relative value of the spectral radiance at the wavelength of 650 nm being 0.94 with the spectral radiance at the wavelength of 550 nm defined as 1. This indicates that the yellow component of the light with the wavelength around 550 nm is suppressed.

Table 1 illustrates a result of visual evaluation on each of light diffusion property, meat color enhancement, and vegetable color enhancement by the LED luminaire of this Example. The result of the visual confirmation indicates that the LED luminaire of this Example uniformly emitted light with no dot-like appearance of the LED chip. The LED luminaire cover light diffuser of this Example achieves suppression of the spectral radiance at the wavelength of 550 nm, and thus can be favorably used in stores, supermarkets, and the like where food products and the like are illuminated.

[Comparative Example 1]

A cylindrical LED luminaire cover light diffuser was prepared in the manner same as that described in Example 1 except that no coloring matter was used. An LED luminaire was prepared in the manner same as that described in Example 1 except that this cylindrical LED luminaire cover light diffuser was used.

Table 1 illustrates a result of measuring the spectral radiance for the LED luminaire obtained. The LED luminaire obtained had the relative value of the spectral radiance at the wavelength of 450 nm being 1.38 with the spectral radiance at the wavelength of 550 nm defined as 1 and the relative value of the spectral radiance at the wavelength of 650 nm being 0.47 with the spectral radiance at the wavelength of 550 nm defined as 1. The spectral radiance of the LED luminaire in the wavelength range from 450 to 650 nm was substantially the same as that of the white LED in the wavelength range from 450 to 650 nm. Thus, the light absorption property of the LED luminaire cover light diffuser was not confirmed.

Table 1 illustrates a result of visual evaluation on each of light diffusion property, meat color enhancement, and vegetable color enhancement by the LED luminaire of this Comparative Example. The LED luminaire of this Comparative Example did not have the spectral radiance at the wavelength of 550 nm suppressed and thus the meat color enhancement and the vegetable color enhancement were no good. Thus, this LED luminaire is difficult to use in stores, supermarkets, and the like where food products and the like are illuminated.

[Comparative Example 2]

A cylindrical LED luminaire cover light diffuser was prepared in the manner same as that described in Example 1 except that no light diffusing agent was used. An LED luminaire was prepared in the manner same as that described in Example 1 except that this cylindrical LED luminaire cover light diffuser was used.

The spectral radiance was unmeasurable for the LED luminaire obtained. Table 1 illustrates a result of visual evaluation on each of light diffusion property, meat color enhancement, and vegetable color enhancement by the LED luminaire of this Comparative Example. The LED luminaire of this Comparative Example had notable dot-like appearance of the LED chip and thus the light diffusion property (of the LED luminaire cover light diffuser) was low.

[Comparative Example 3]

A cylindrical LED luminaire cover light diffuser was prepared in the manner same as that described in Example 1 except that the concentration of the coloring matter in the mixture was changed to 500 ppm per weight. An LED luminaire was prepared in the manner same as that described in Example 1 except that this cylindrical LED luminaire cover light diffuser was used.

Table 1 illustrates a result of measuring the spectral radiance for the LED luminaire obtained. The LED luminaire obtained had the relative value of the spectral radiance at the wavelength of 450 nm being 18.17 with the spectral radiance at the wavelength of 550 nm defined as 1 and the relative value of the spectral radiance at the wavelength of 650 nm being 45.42 with the spectral radiance at the wavelength of 550 nm defined as 1.

Table 1 illustrates a result of visual evaluation on each of light diffusion property, meat color enhancement, and vegetable color enhancement by the LED luminaire of this Comparative Example. When meat and vegetable are illuminated by using the LED luminaire of the this Comparative Example, all of them were illuminated in red, indicating that the LED luminaire is difficult to use in stores, supermarkets, and the like where food products and the like are illuminated.

[Comparative Example 4]

A cylindrical LED luminaire cover light diffuser was prepared in the manner same as that described in Example 1 except that the concentration of the coloring matter in the mixture was changed to 0.05 ppm per weight. An LED luminaire was prepared in the manner same as that described in Example 1 except that this cylindrical LED luminaire cover light diffuser was used.

Table 1 illustrates a result of measuring the spectral radiance for the LED luminaire obtained. The LED luminaire obtained had the relative value of the spectral radiance at the wavelength of 450 nm being 1.39 with the spectral radiance at the wavelength of 550 nm defined as 1 and the relative value of the spectral radiance at the wavelength of 650 nm being 0.48 with the spectral radiance at the wavelength of 550 nm defined as 1. The spectral radiance of the LED luminaire in the wavelength range from 450 to 650 nm was substantially the same as that of the white LED in the wavelength range from 450 to 650 nm. Thus, the light absorption property of the LED luminaire cover light diffuser was not confirmed.

Table 1 illustrates a result of visual evaluation on each of light diffusion property, meat color enhancement, and vegetable color enhancement by the LED luminaire of this Comparative Example. The LED luminaire of this Comparative Example did not have the spectral radiance at the wavelength of 550 nm suppressed and thus the meat color enhancement and the vegetable color enhancement were no good. Thus, this LED luminaire is difficult to use in stores, supermarkets, and the like where food products and the like are illuminated.

[Table 1]

As described above, the LED luminaire cover light diffuser of Comparative Example 1 does not include the coloring matter that at least partially absorbs light in a wavelength range from 500 to 600 nm and thus cannot achieve good meat color enhancement and vegetable color enhancement.

The LED luminaire cover light diffusers of Comparative Examples 1 and 4 resulted in the relative value of the spectral radiance at the wavelength of 450 nm being smaller than 1.60 with the spectral radiance at the wavelength of 550 nm defined as 1, when the spectral radiance was measured with the white LED having the first peak of the spectral radiance in the wavelength range from 440 to 460 nm and having the second peak of the spectral radiance in the wavelength range from 545 to 575 nm used as the measurement light source and with the LED luminaire cover light diffuser provided to cover the white LED, and thus cannot achieve good meat color enhancement and vegetable color enhancement.

The LED luminaire cover light diffuser of Comparative Example 3 resulted in the relative value of the spectral radiance at the wavelength of 450 nm being larger than 15 with the spectral radiance at the wavelength of 550 nm defined as 1, when the spectral radiance was measured with the white LED having the first peak of the spectral radiance in the wavelength range from 440 to 460 nm and having the second peak of the spectral radiance in the wavelength range from 545 to 575 nm used as the measurement light source and with the LED luminaire cover light diffuser provided to cover the white LED, and thus cannot achieve good meat color enhancement and vegetable color enhancement.

On the other hand, the LED luminaire cover light diffusers of Examples 1 to 19 achieve the relative value of the spectral radiance at the wavelength of 450 nm within a range from 1.60 to 15 with the spectral radiance at the wavelength of 550 nm defined as 1, when the spectral radiance is measured with the white LED having the first peak of the spectral radiance in the wavelength range from 440 to 460 nm and having the second peak of the spectral radiance in the wavelength range from 545 to 575 nm used as the measurement light source and with the LED luminaire cover light diffuser provided to cover the white LED, and thus can achieve an LED luminaire achieving excellent meat color enhancement and vegetable color enhancement, when used for the LED luminaire cover of the LED luminaire using a white LED as the light source (Examples 1 to 6, 13, 14, and 17 to 19), or used for the LED luminaire cover of the LED luminaire using a high-color LED as the light source (Examples 7 to 12, 15, and 16).

The LED luminaire cover light diffuser of Comparative Example 3 has the content of the coloring matter with no absorption range in the wavelength range from 650 to 750 nm being larger than 10 ppm per weight (specifically, 500 ppm per weight), and thus cannot achieve good meat color enhancement and vegetable color enhancement. On the other hand, the LED luminaire cover light diffusers of Examples 1 to 19 have the content of the coloring matter with no absorption range in the wavelength range from 650 to 750 nm being equal to or smaller than 10 ppm per weight (specifically, 0.5 to 10 ppm per weight), and thus can achieve an LED luminaire achieving excellent meat color enhancement and vegetable color enhancement.

The LED luminaire cover light diffuser of Comparative Example 4 has the content of the coloring matter with no absorption range in the wavelength range from 650 to 750 nm being smaller than 0.1 ppm per weight (specifically, 0.05 ppm per weight), and thus cannot achieve good meat color enhancement and vegetable color enhancement. On the other hand, the LED luminaire cover light diffusers of Examples 1 to 19 have the content of the coloring matter with no absorption range in the wavelength range from 650 to 750 nm being equal to or larger than 0.1 ppm per weight (specifically, 0.5 to 10 ppm per weight), and thus can achieve an LED luminaire achieving excellent meat color enhancement and vegetable color enhancement.

As described above, the LED luminaire cover light diffuser of Comparative Example 2 does not include the light diffusing agent and thus has poor light diffusion property. On the other hand, the LED luminaire cover light diffusers of Examples 1 to 19 include the light diffusing agent and thus have excellent light diffusion property.

The LED luminaires of Comparative Examples 1 and 4 has the relative value of the spectral radiance at the wavelength of 450 nm being smaller than 1.60 with the spectral radiance at the wavelength of 550 nm defined as 1, and thus cannot achieve good meat color enhancement and vegetable color enhancement. The LED luminaire of Comparative Example 3 has the relative value of the spectral radiance at the wavelength of 450 nm being larger than 15 with the spectral radiance at the wavelength of 550 nm defined as 1, and thus cannot achieve good meat color enhancement and vegetable color enhancement. On the other hand, the LED luminaires of Examples 1 to 19 have the relative value of the spectral radiance at the wavelength of 450 nm being within a range from 1.60 to 15 with the spectral radiance at the wavelength of 550 nm defined as 1, and thus can achieve excellent meat color enhancement and vegetable color enhancement.

**Claims**

1. An LED luminaire cover light diffuser used for an illumination cover of an LED luminaire that illuminates a target object to enable the target object to be seen, the LED luminaire cover light diffuser comprising:

    base resin;
    light diffusing agent; and
    a coloring matter that at least partially absorbs light in a wavelength range from 500 to 600 nm, wherein
    the LED luminaire cover light diffuser achieves a relative value of spectral radiance at a wavelength of 450 nm within a range from 1.60 to 15 with the spectral radiance at the wavelength of 550 nm defined as 1, when the spectral radiance is measured with a white LED having a first peak of the spectral radiance in a wavelength range from 440 to 460 nm and having a second peak of the spectral radiance in a wavelength range from 545 to 575 nm used as a measurement light source and with the LED luminaire cover light diffuser provided to cover the white LED.

2. The LED luminaire cover light diffuser according to claim 1, wherein a relative value of the spectral radiance at a wavelength of 650 nm with the spectral radiance at the wavelength of 550 nm defined as 1 is within a range from 0.6 to 20 when the spectral radiance is measured with the LED luminaire cover light diffuser provided to cover the white LED.

3. The LED luminaire cover light diffuser according to claim 1 or 2, wherein
    the coloring matter has a maximum absorption peak in a wavelength range from 550 to 600 nm,
    an amount of the light diffusing agent is within a range from 0.1 to 5 parts by weight relative to 100 parts by weight of the base resin, and
    an amount of the coloring matter is within a range from 0.1 to 10 ppm per weight relative to 100 parts by weight of the base resin.

4. The LED luminaire cover light diffuser according to any one of claims 1 to 3, wherein the LED luminaire cover light diffuser has a multilayered structure including:

    a first resin layer including the base resin and the light diffusing agent; and
    a second resin layer including the base resin and the coloring matter that at least partially absorbs light in a wavelength range from 500 to 600 nm.

5. The LED luminaire cover light diffuser according to claim 4, the multilayered structure further includes at least one another layer having a refractive index different from refractive indices of the first resin layer and the second resin layer between the first resin layer and the second resin layer.

6. The LED luminaire cover light diffuser according to any one of claims 1 to 5, wherein
    the base resin is polycarbonate-based resin, and
    the light diffusing agent includes silicone-based resin particles.

7. The LED luminaire cover light diffuser according to any one of claims 1 to 6, wherein the coloring matter that at least partially absorbs light in a wavelength range from 500 to 600 nm is dye.

8. The LED luminaire cover light diffuser according to any one of claims 1 to 7, wherein an absorption rate for the light at the wavelength of 550 nm is within a range from 20 to 90%.

9. The LED luminaire cover light diffuser according to any one of claims 1 to 8, wherein the LED luminaire cover light diffuser is used for an LED luminaire cover of an LED luminaire that uses a white LED as a light source.

10. The LED luminaire cover light diffuser according to any one of claims 1 to 9, wherein the LED luminaire cover light diffuser is used for an LED luminaire cover of an LED luminaire that illuminates a food product or a display item.

11. An LED luminaire cover light diffuser used for an illumination cover of an LED luminaire that illuminates a target object to enable the target object to be seen, the LED luminaire cover light diffuser comprising:

100 parts by weight of base resin;
0.1 to 5 parts by weight of light diffusing agent; and
0.1 to 10 ppm per weight of a coloring matter having a maximum absorption peak in a wavelength range from 550 to 600 nm.

12. An LED luminaire comprising the LED luminaire cover light diffuser according to any one of claims 1 to 11.

13. An LED luminaire that illuminates a target object to enable the target object to be seen, the LED luminaire comprising:

an LED; and
an LED luminaire cover including base resin, light diffusing agent, and a coloring matter that at least partially absorbs light in a wavelength range from 500 to 600 nm, wherein
the LED luminaire achieves a relative value of spectral radiance at a wavelength of 450 nm within a range from 1.60 to 15 with the spectral radiance at a wavelength of 550 nm defined as 1.

Fig.1

Fig.2

Fig.3

Fig.4

6

7

Fig.5

SPECTRAL RADIANCE (W sr⁻¹ m⁻² nm⁻¹)

WAVELENGTH (nm)

Legend:
- - - - WHITE LED + COLORING MATTER UNADDED COVER
- - - HIGH-COLOR LED + COLORING MATTER UNADDED COVER
——— EXAMPLE 1

Fig.6

Fig.7

Fig.8

**EP 3 517 836 A1**

# INTERNATIONAL SEARCH REPORT

International application No.

PCT/JP2017/007911

A. CLASSIFICATION OF SUBJECT MATTER
$F21V3/04$(2006.01)i, $F21S2/00$(2016.01)i, $G02B5/02$(2006.01)i, $G02B5/22$
(2006.01)i, $H01L33/00$(2010.01)i, $H01L33/58$(2010.01)i,
$F21W131/10$(2006.01)n,
$F21W131/402$(2006.01)n, $F21W131/405$(2006.01)n, $F21Y103/10$(2016.01)n,

According to International Patent Classification (IPC) or to both national classification and IPC

B. FIELDS SEARCHED

Minimum documentation searched (classification system followed by classification symbols)
F21V3/04, F21S2/00, G02B5/02, G02B5/22, H01L33/00, H01L33/58, F21W131/10,
F21W131/402, F21W131/405, F21Y103/10, F21Y113/17, F21Y115/10

Documentation searched other than minimum documentation to the extent that such documents are included in the fields searched
Jitsuyo Shinan Koho          1922-1996    Jitsuyo Shinan Toroku Koho   1996-2017
Kokai Jitsuyo Shinan Koho    1971-2017    Toroku Jitsuyo Shinan Koho   1994-2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-193581 A (Matsushita Electric Industrial Co., Ltd.), 08 July 2004 (08.07.2004), paragraphs [0030] to [0098]; fig. 2, 4, 7, 8, 9 & US 2004/0119086 A1 paragraphs [0053] to [0123]; fig. 2, 4A, 4B, 7B, 8B, 9A & CN 1503382 A | 1-13 |
| A | WO 2011/108203 A1 (Panasonic Corp.), 09 September 2011 (09.09.2011), paragraphs [0012] to [0086]; fig. 25, 2 & JP 5497757 B2       & US 2012/0300432 A1 paragraphs [0041] to [0134]; fig. 25A, 2A, 2B & WO 2011/108053 A1     & EP 2543920 A1 & CN 102782396 A | 1-13 |

☒ Further documents are listed in the continuation of Box C.    ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T"  later document published after the international filing date or priority date and not in conflict with the application but cited to understand the principle or theory underlying the invention

"X"  document of particular relevance; the claimed invention cannot be considered novel or cannot be considered to involve an inventive step when the document is taken alone

"Y"  document of particular relevance; the claimed invention cannot be considered to involve an inventive step when the document is combined with one or more other such documents, such combination being obvious to a person skilled in the art

"&"  document member of the same patent family

| Date of the actual completion of the international search | Date of mailing of the international search report |
|---|---|
| 18 April 2017 (18.04.17) | 25 April 2017 (25.04.17) |

| Name and mailing address of the ISA/ Japan Patent Office 3-4-3,Kasumigaseki,Chiyoda-ku, Tokyo 100-8915,Japan | Authorized officer |
|---|---|
| | Telephone No. |

Form PCT/ISA/210 (second sheet) (January 2015)

**INTERNATIONAL SEARCH REPORT**

International application No.

PCT/JP2017/007911

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2016-149229 A  (Panasonic Intellectual Property Management Co., Ltd.), 18 August 2016 (18.08.2016), paragraphs [0012] to [0107]; fig. 3, 7 & DE 102016101328 A1 | 1-13 |

Form PCT/ISA/210 (continuation of second sheet) (January 2015)

**INTERNATIONAL SEARCH REPORT**

International application No.

PCT/JP2017/007911

Continuation of A. CLASSIFICATION OF SUBJECT MATTER
(International Patent Classification (IPC))

*F21Y113/17*(2016.01)n, *F21Y115/10*(2016.01)n

(According to International Patent Classification (IPC) or to both national
classification and IPC)

Form PCT/ISA/210 (extra sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014170082 A

- JP 2010170866 A